Europäisches Patentamt

(19) European Patent Office

Office européen des brevets

(11) EP 0 822 659 A2

(12) EUROPEAN PATENT APPLICATION

(43) Date of publication:
04.02.1998 Bulletin 1998/06

(51) Int. Cl.$^6$: H03H 19/00

(21) Application number: 97113128.9

(22) Date of filing: 30.07.1997

(84) Designated Contracting States:
AT BE CH DE DK ES FI FR GB GR IE IT LI LU MC NL PT SE

(30) Priority: 31.07.1996 JP 217851/96

(71) Applicants:
• YOZAN INC.
Tokyo 155 (JP)
• SHARP KABUSHIKι KAISHA
Osaka 545 (JP)

(72) Inventors:
• Yamamoto, Makoto,
c/o Yozan Inc.
Tokyo 155 (JP)

• Shou, Guoliang,
c/o Yozan Inc.
Tokyo 155 (JP)
• Takatori, Sunao,
c/o Yozan Inc.
Tokyo 155 (JP)

(74) Representative:
Grünecker, Kinkeldey,
Stockmair & Schwanhäusser
Anwaltssozietät
Maximilianstrasse 58
80538 München (DE)

(54) **Switched capacitor circuit**

(57) The present invention has an object to provide a switched capacitor for reducing electric power consumption. To realize this, an odd number of stages of CMOS inverters are used as active components.

FIG. 1

**Description**

FIELD OF THE INVENTION

The present invention relates to a switched capacitor circuit.

BACKGROUND OF THE INVENTION

A switched capacitor circuit (hereinafter, SC circuit) is a main component of transmission and signal processing filters in large-scale integration circuits because it performs a variety of functions and reduces electric power. Ir does so by opening and closing a plurality of switches based on the principle of conservation of capacitance energy. Operational amplifiers are used to maintain the dynamic range of an SC circuit and to minimize the influence of parasitic capacity.

SUMMARY OF THE INVENTION

Since operational amplifiers are usually differential amplifiers that generate output voltage in response to electric current disparities with the input voltage, there is constant generation of excess current within SC circuits. Therefore, conventional SC circuits have limitations unless there is improvement in reducing the current they produce.

The present invention solves the conventional problems and has an object to provide an SC circuit consuming lower electric power.

An SC circuit according to the present invention uses an inverting amplifying means including an odd number of stages of CMOS inverters instead of a operational amplifier.

BRIEF DESCRIPTION OF THE DRAWINGS

FIG. 1 shows the first embodiment of a switched capacitor circuit according to the present invention.
FIG. 2 shows a passive switched capacitor in the embodiment in FIG. 1.
FIG. 3 shows an inverting amplifying means in the embodiment in FIG. 1.
FIG. 4 shows a CMOS inverter in the inverting amplifying circuit in FIG. 3.
FIG. 5 shows a switch used in the embodiment in FIG. 1.
FIG. 6 shows a variation of a passive switched capacitor in FIG. 2.
FIG. 7 shows a multiplexer in the variation in FIG. 6.

PREFERRED EMBODIMENT OF THE PRESENT INVENTION

Hereinafter, an SC circuit according to the present invention is described with reference to the attached drawings.

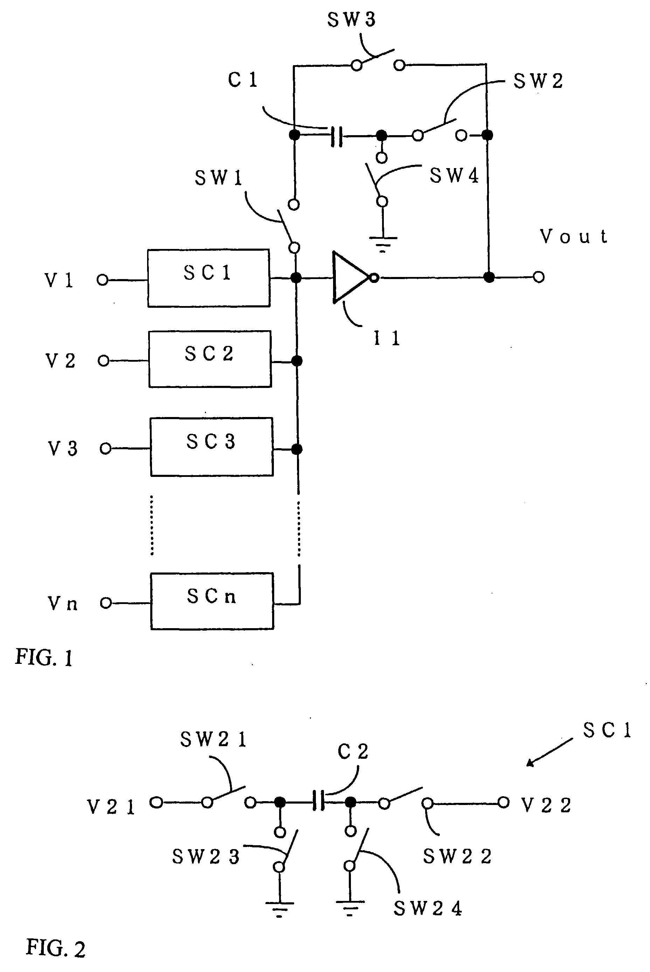

FIG. 1 shows a switched capacitor circuit including a plurality of passive switched capacitor circuits SC1 to SCn, to which input voltages V1 to Vn are input, respectively. The Output of SC1 to SCn are integrated and connected to the input of inverting amplifying means I1.
FIG. 2 shows a passive switched capacitor SC1 including switch SW21 connected to input voltage V21 (which corresponds to V1 in FIG. 1), input capacitance C2 whose input is connected to SW21, and switch SW22 connected to the output of C2. Output voltage V22 is output from SW22.
To the input and output of input capacitance C2, grounded switches SW23 and SW24 are connected, respectively. Each terminal of C2 can be individually grounded.
In SC1, the electrical charge is held in C2 according to the difference between V21 and V22 when SW21 and SW22 are closed. Assuming the electrical charge to be Q, Q is expressed by formula (1):

$$Q = C \cdot (V21 - V22) \tag{1}$$

When SW21 and SW24 are closed, electrical charge Q corresponding to V21 is given. This is expressed by formula (2):

$$Q = C \cdot (V21 - 0) = C \cdot V21 \tag{2}$$

Thereafter, when SW21 and SW24 are opened and SW23 and SW22 are closed, formula (3) is true:

$$Q = C \cdot (0 - V22) \tag{3}$$

Formulas (4) and (5) are derived from formulas (2) and (3):

$$C \cdot V21 = C \cdot (0 - V22) \qquad (4)$$

$$\therefore V22 = -V21 \qquad (5)$$

From them, it is clear that an inverse output V21 can be generated.

Between the input and output of I1, feedback capacitance C1 is connected through switches SW1 and SW2. When SW1 and SW2 are closed, output voltage Vout of I1 is shown in formulas (6) and (7). In these formulas, input capacitance C2 of each passive switched capacitor SCi is expressed by C2i, and the inversion and non-inversion of input voltage Vi is expressed by sign(i). When it is inverse, sign(i)=-1, and when it is not inverse, sign(i)=1:

$$C1 \cdot (V22 - Vout) + \sum_{i=1}^{n} C2i \cdot (Vi \cdot sign(i) - V22) = 0 \qquad (6)$$

$$C1 \cdot Vout = \sum_{i=1}^{n} C2i \cdot Vi \cdot sign(i) + V22\left(C1 - \sum_{i=1}^{n} C2i\right) \qquad (7)$$

Hereafter, equation (8) is defined, and weighted addition with symbols is performed in formula (9):

$$C1 = \sum_{i=1}^{n} C2i \qquad (8)$$

$$Vout = \frac{\sum_{i=1}^{n} C2i \cdot Vi \cdot sign(i)}{\sum_{i=1}^{n} C2i} \qquad (9)$$

When C2i is a constant value as in (10), formula (9) is a simple voltage addition with symbols:

$$C21 = C22 = ... = C2n \qquad (10)$$

When V1 to Vn are the common input voltage Vc, and C21 to C2n are values proportional to the ratio of the power of 2, equation (11) is true:

$$Vout = \frac{Vc \cdot \sum_{i=1}^{n} 2^{i} \cdot bi}{\sum_{i=1}^{n} 2^{i}} \qquad (11)$$

In equation (II), bi=1, 0, or -1, and Vc and these binary numbers are multiplied as shown. The value of bi is 0 when the output of Sci is grounded, and it is 1 when the output of Sci is connected to the output voltage of C2. By this connection, bi=0 when SW22 and SW24 are closed, bi=1 when SW21 and SW22 are closed, and bi=-1 when SW22 and SW23 are closed.

I1 in FIG. 1 usually generates offset voltage: offset voltage Voff ($\neq$0V) is generated when the input voltage is 0V. To reduce the offset voltage, switch SW3 for connecting the output of I1 to the input of C1, and switch SW4 for connecting the output of C1 to the ground, are provided.

When SW2 is opened and SW1 SW3, SW4, SW22 and SW23 are closed, Voff is added to the input of C1, and 0V (the ground) is added to its output. Consequently, electrical charge Q corresponding to Voff is produced in C1 and C2 as expressed in formula (12):

$$Q=\sum_{i=1}^{n} C2i \cdot (-Voff)+C1 \cdot (-Voff) \tag{12}$$

After that, when one or more signal voltage(s) among V1 to Vn is input, the electrical charge is produced in C2i and C1 as shown in formula (13):

$$Q=\sum_{i=1}^{n} C2i \cdot (Vi-Voff)+C1 \cdot (Vout-Voff) \tag{13}$$

From the principle of conservation of charge, as electrical charges Q in formulas (12) and (13) are equal, formulas (14), (15) and (16) are derived from them:

$$Q=\sum_{i=1}^{n} C2i \cdot (-Voff)+C1 \cdot (-Voff)=\sum_{i=1}^{n} C2i \cdot (Vi-Voff)+C1 \cdot (Vout-Voff) \tag{14}$$

$$\sum_{i=1}^{n} C2i \cdot Vi+C1 \cdot Vout=0 \tag{15}$$

$$\therefore Vout=-\sum_{i=1}^{n} C2i \cdot Vi \tag{16}$$

From formulas (15) and (16), the offset voltage is cancelled.

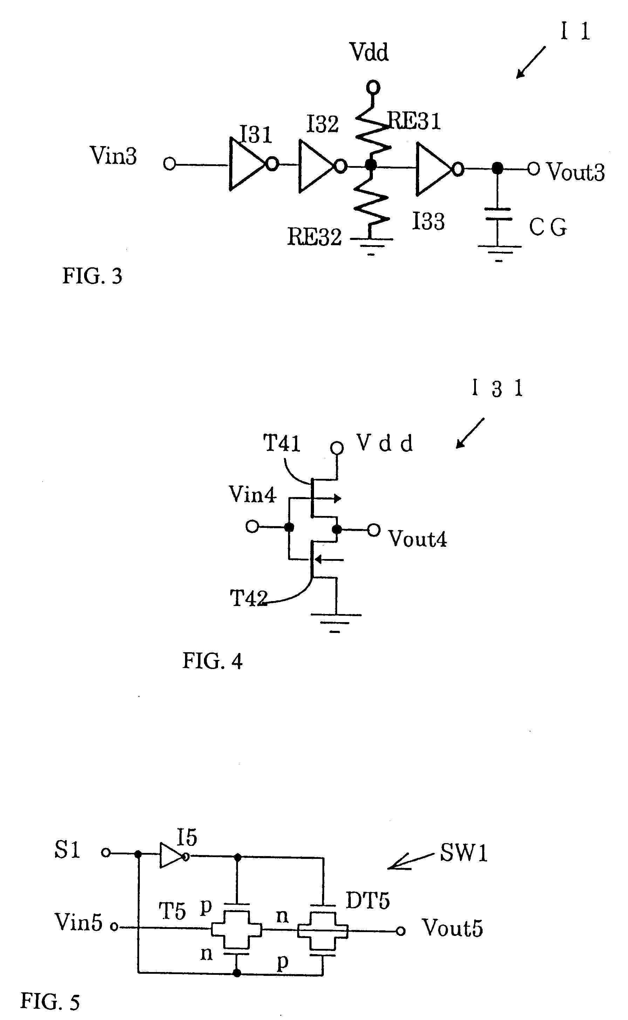

FIG. 3 shows the structure of inverting amplifying means I1. In I1, CMOS inverters I31, I32 and I33 are serially connected in a three-stage configuration. To the output of the last-stage CMOS inverter I33, grounded capacitance CG is connected. The high-frequency gain of the inverting amplifying means is decreased by its low-pass characteristics. When it causes a feedback route including C1 through closing switch SW2, oscillation is prevented.

A balancing resistance containing a pair of resistances RE31 and RE32 connected to the supply voltage and the ground, respectively, is connected to the output of I32, at the next-to-last stage. As the balancing resistance is the load of I32, the resulting gain of I32 is decreased to lower the closed loop gain of I1. CG and the balancing resistance above perfectly prevent both oscillation of the circuit including I1 and the feedback route and thus guarantee the output accuracy.

FIG. 4 shows the structure of CMOS inverter I31 in FIG. 3. In I31, a pMOS and an nMOS transistors (respectively shown by T41 and T42) are serially connected in the direction from the supply voltage to the ground, and input voltage Vin4 (which corresponds to Vin3 in FIG. 3) is connected to their gates. Output voltage Vout4 is output from the drains of both pMOS and nMOS. As I32 and I33 are similar in structure to I31, their description is omitted.

FIG. 5 shows the structure of switch SW1 in FIG. 1. SW1 includes analog switch T5 which connects a pMOS and nMOS transistors so that each of their drains is connected to the source of the other. Input voltage Vin5 is connected to T5. Control signal S1 is input to the nMOS gate, and through inverter I5 to the pMOS gate. When S1 is high-level, T5 is conductive; when S1 is low-level, T5 is cutoff. Dummy transistor DT5 is connected to the output of T5. DT5 has a structure similar to, and MOSs with polarity opposite to, that of T5, whose sources and drains are short-cut so as to cancel the capacity of T5 and prevent the influence on adjacent capacitances C2 and C1. In this way computation accuracy of the whole circuit is secured. A dummy transistor should be connected to the side of the adjacent capacitance. For example, with respects to SW1 and SW2, it should be connected to the side of C1, and with respect to SW21 and SW22, both sides should be connected. No dummy transistor is necessary when high accuracy is not required. In this case, control signals can be integrated, and the circuit module of a multiplexer can be used to simplify the circuit.

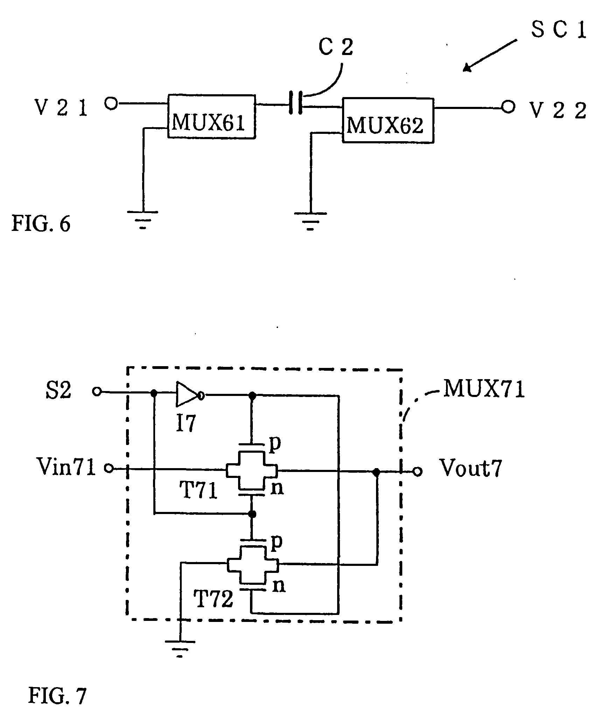

FIG. 6 shows the second embodiment in which the circuit is simplified as above. In this embodiment, multiplexer MUX61 is used instead of switches SW21 and SW23, and multiplexer MUX62 is used instead of SW22 and SW24.

FIG. 7 shows the structure of MUX61. MUX61 includes analog switches T71 and T72 whose pMOSs and nMOSs are connected to each other so that each of their drains is connected to the source of the other. T71 is connected to input voltage Vin71, and T72 is connected to the ground. Control signal S2 is input to the nMOS gate of T71 and through inverter I7 to the pMOS gate. When S2 is high-level, T71 is conductive; when S2 is low-level, T71 is cutoff. With respect to T72, control signal S2 is input to the pMOS gate and through inverter 17 to the nMOS gate. Therefore, T72 is conductive when S2 is low-level, and it is cutoff when S2 is high-level. As MUX62 is similar in structure to MUX61, its description is omitted.

As mentioned above, in an SC circuit according to the present invention, an inverting amplifying means including an odd number of stages of CMOS inverters is used instead of a operational amplifier. Therefore, multiplication and other computations with signs can be performed consuming less electric power than conventional circuits.

**Claims**

1. A switched capacitor circuit comprising:

    i) a plurality of passive switched capacitor circuits consisting of:

        a) a first switch connected to an input voltage,
        b) an input capacitance whose input is connected to an the output of said first switch,
        c) a second switch connected to an output of said input capacitance,
        d) a third switch for connecting an input of said input capacitance to the ground, and
        e) a fourth switch for connecting an output of said input capacitance to the ground;

    ii) an inverting amplifying means comprising an odd number of stages of CMOS inverters whose inputs are connected to said output of said second switch of each passive switched capacitor circuit; and
    iii) a feedback capacitance whose input and output are connected to an input and output of said inverting amplifying means, respectively.

2. A switched capacitor circuit as claimed in claim 1, further comprising:

    i) a fifth switch connected between said input of said feedback capacitance and said input of said inverting amplifying means;
    ii) a sixth switch connected between said output of said feedback capacitance and said output of said inverting amplifying means;
    iii) a seventh switch connected between said input of said feedback capacitance and said output of said inverting amplifying means;
    iv) an eighth switch, connected between said sixth switch and said feedback capacitance, for connecting said output of said feedback capacitance to the ground.

3. A switched capacitor circuit as claimed in claim 1, wherein a grounded capacitance is connected to said output of the last-stage CMOS inverter in said inverting amplifying means, and a pair of balancing resistances in which one of said pair and the other of them are connected to the supply voltage and the ground, respectively, are connected to said output of one or more stages of CMOS inverters except the last-stage one.

4. A switched capacitor circuit as claimed in claim 1, wherein said input capacitance in each of said passive switched capacitor circuits has equal capacity.

5. A switched capacitor circuit as claimed in claim 1, wherein said input capacitance in each said passive switched capacitor circuit is provided stepwise with the ratio of the n-th power of 2, and each said passive switched capacitor has a common input voltage.

SW3

C1

SW2

SW1

SW4

Vout

V1 —○— SC1

I1

V2 —○— SC2

V3 —○— SC3

Vn —○— SCn

FIG. 1

SW21

C2

SC1

V21

V22

SW23

SW22

SW24

FIG. 2

Vdd

I 1

Vin3 ○ ▷ I31 ▷ I32 ● RE31 ▷ ● ○ Vout3

RE31

RE32 ⏚ I33 C G

FIG. 3

I 3 1

T41 ○ V d d

Vin4 ○ ● ● ○ Vout4

T42 ⏚

FIG. 4

S1 ○ ● ▷ I5 ● SW1

T5 p n DT5

Vin5 ○ ○ Vout5

n p

FIG. 5

FIG. 6

FIG. 7